# EUROPEAN PATENT SPECIFICATION

(11) **EP 0 388 161 B1**
(45) Date of publication and mention of the grant of the patent: **12.10.1994**
(21) Application number: 90302690.4
(22) Date of filing: 14.03.1990
(51) Int. Cl.: H01L 27/14, H01L 31/105, H04B 10/14

(54) **Semiconductor device having pin photodiodes**
Halbleitereinrichtung mit pin-Photodiode
Dispositif semiconducteur ayant une photodiode pin

(30) Priority: 14.03.1989 JP 61544/89; 20.05.1989 JP 125585/89
(43) Date of publication of application: 19.09.1990
(73) Proprietor: FUJITSU LIMITED, Kawasaki-shi, Kanagawa 211 (JP)
(72) Inventor: Makiuchi, Masao, Yamato-shi, Kanagawa 242 (JP); Sanada, Tatsuyuki, Yokohama-shi, Kanagawa 227 (JP); Wada, Osamu, Isehara-shi, Kanagawa 259-11 (JP)
(74) Representative: Stebbing, Timothy Charles

(56) References cited:
- ELECTRONICS LETTERS, vol. 24, no. 23, 10 November 1988, ENAGE GB, pp. 1457-1458 ; S. Chandrasekhar et al.: "Balanced dual photodiodes integrated with a 3dB directional coupler for coherent lightwave receiver"
- ELECTRONICS LETTERS, vol. 22, no. 8, 10 April 1986, ENAGE GB, pp. 413-415 ; B.L. Kasper et al.: "Balanced dual-detector receiver for optical heterodyne communication at Gbit/s rates"
- ELECTRONICS LETTERS, vol. 24, no. 2, 21 January 1988, ENAGE GB, pp. 109-110 ; M. Makiuchi et al.: "Small-junction-area GaInAs/InP pin photodiode with a monolithic microlens"
- ELECTRONICS LETTERS, vol. 21, no. 14, July 1985, ENAGE GB, pp. 593-595 ; R.S. Sussmann et al.: "Ultra-low-capacitance flip-chip-bonded GaInAs PIN photodetector for long-wavelength high-data-rate fibre-optic systems"
- ELECTRONICS LETTERS, vol. 24, no. 9, 28 April 1988, ENAGE GB, pp. 514-516 ; O. Wada et al.: "Fabrication of monolithic twin-GaInAs pin photodiode for balanced dual-detector optical coherent receivers"
- ECOC 87 Technical Digest vol. I, August 1988, CPEF c/o Sähköinsinööriliitto R.Y., pp. 39-42 ; K. Matsuda et al.: "A monolithically integrated InGaAs/InP photoreceiver operating with a single 5V power supply"

## Description

### BACKGROUND OF THE INVENTION

The present invention generally relates to semiconductor devices, and more particularly to a semiconductor device which has semiconductor light receiving elements and is suited for use in a coherent optical communication system.

Presently, there are demands to increase the communication speed in the field of communication systems, and the coherent optical communication is one effective means for realizing the high-speed communication.

There is a proposal to employ the heterodyne detection system for the coherent optical communication. A signal obtained according to this system has a frequency which is a difference or a sum of the frequency of an actual optical signal and the frequency of an oscillation light from a local oscillator which is made up of a laser diode. For this reason, the signal-to-noise (S/N) ratio is improved and it is possible to improve the minimum signal reception level of an optical signal receiver.

A dual balanced optical receiver which is made up of two pin photodiodes is used as the optical signal receiver. Uniform optical and electrical characteristics are demanded of the two pin photodiodes of the optical signal receiver.

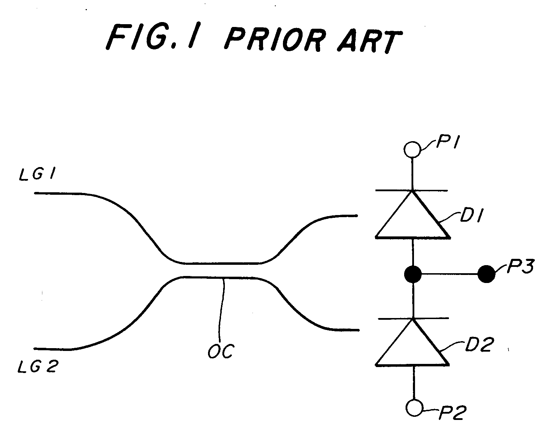

FIG.1 is a diagram for explaining a dual balanced optical receiver made up of two pin photodiodes. The dual balanced optical receiver generally comprises pin photodiodes D1 and D2, a positive power source pad P1, a negative power source pad P2, a signal output pad P3, an optical waveguide LG1 for introducing an optical signal, an optical waveguide LG2 for introducing an oscillation light from a local oscillator, and an optical coupler OC which is made up of an optical fiber, a semiconductor or a dielectric material.

In this dual balanced optical receiver, the optical signal input from the optical waveguide LG1 and the oscillation light input from the optical waveguide LG2 are mixed in the optical coupler OC and then input to the pin photodiodes D1 and D2. An electrical signal having a frequency which is a difference or a sum of the frequency of an optical signal and the frequency of the oscillation light is obtained from the signal output pad P3. Of course, the selected frequency is an intermediate frequency apart from the frequency of the optical carrier of the optical signal. In addition, the electrical signal which is obtained from the signal output pad P3 is amplified in an intermediate frequency amplifier and then subjected to an appropriate detection depending on the modulation system so as to obtain a base band signal. For example, the appropriate detection is an envelope detection, a delay detection, a synchronous detection and the like.

When making the dual balanced optical receiver shown in FIG. 1, two pin photodiodes having approximately the same characteristics are selected and used as the pin photodiodes D1 and D2, and there are only few examples of monolithic integrated circuits which have two pin photodiodes provided on the same semiconductor substrate. But in order to further increase the communication speed of the coherent optical communication, it is important that the characteristics of the two pin photodiodes are uniform and that the stray capacitances of the pin photodiodes and electrical interconnections are made as small as possible. For this reason, it is considered essential that the semiconductor light receiving elements and the like are integrated on the same semiconductor substrate in the form of a monolithic integrated circuit.

One recent integrated construction is shown in Electronics Letters, Volume 24, no. 9, page 514 (Wada et al.), which has two similar integrated photodiodes with an Au/Ti interconnection and wire-bonding pads. A further development is described in no. 23 of the same journal volume, page 1457 (Chandrasekhar et al.), where a waveguide coupler is also integrated on to the chip, and symmetrical operating characteristics are obtained.

When a plurality of *pin* photodiodes are formed on the same semiconductor substrate, it should be easier to make their characteristics uniform compared to the case where independent *pin* photodiodes are provided. However, the layout of the elements of the monolithic integrated circuit has not hitherto allowed the construction of a dual balanced optical receiver having satisfactory optical and electrical balance characteristics.

Accordingly, it is a general object of the present invention to provide a novel and useful semiconductor device according to the preamble of claim 1 in which the problems described above are eliminated.

According to the present invention there is provided a semiconductor device comprising a substrate; and first and second semiconductor light-receiving elements monolithically integrated on the substrate and being connected in series via a node, the light-receiving elements each having a first terminal and a second terminal, the second terminal of the first semiconductor light-receiving element and the first terminal of the second semiconductor light-receiving element being connected to this node,
characterized in that there are further provided on the surface of the semiconductor device: a first flip-chip bonding pad electrically coupled to the node; and second and third flip-chip bonding pads electrically coupled to the said first and second terminals, respectively, the bonding pads being spaced apart from the light-receiving elements and the layout of the light-receiving elements and second and third pads being substantially symmetrical about a line passing through the first pad, so that the distance between the centers of the first and second flip-chip bonding pads is approximately the same as the distance between the centers of the first and third flip-chip bonding pads.

With the semiconductor device of the present invention it is possible to stabilise the optical and electrical balance characteristics of the semiconductor light-receiving elements and the related flip-chip bonding pads and realize a satisfactory dual balanced optical receiver.

Flip-chip bonding for photodiodes is known - see for instance Electronics letters Volume 21, no. 14, page 593-595 (Sussman et al.); since here the bonding of only a single diode is considered questions of symmetry and balance do not arise, however.

Other objects and further features of the present invention will be apparent from the following detailed description of embodiments of the invention when read in conjunction with the accompanying drawings.

### BRIEF DESCRIPTION OF THE DRAWINGS

FIG.1 is a diagram for for explaining a dual balanced optical receiver made up of two pin photodiodes;
FIGS.2 through 5 are diagrams for explaining an operating principle of a semiconductor device according to the present invention;
FIG.6 is a perspective view showing an essential part of a first embodiment of the semiconductor device according to the present invention;
FIG.7 is a cross sectional view of the first embodiment along a line X-X in FIG.6;
FIG.8 is a perspective view showing an essential part of a second embodiment of the semiconductor device according to the present invention;
FIGS.9A through 9D are cross sectional views for explaining a method of producing the second embodiment shown in FIG.8;
FIG.10 is a perspective view generally showing a third embodiment of the semiconductor device according to the present invention;
FIG.11 is a perspective view generally showing a fourth embodiment of the semiconductor device according to the present invention;
FIG.12 is a cross sectional view generally showing a fifth embodiment of the semiconductor device according to the present invention;
FIG.13 is an equivalent circuit diagram of the twin pin photodiodes shown in FIG.12;
FIG.14 is a cross sectional view generally showing a sixth embodiment of the semiconductor device according to the present invention;
FIG.15 is an equivalent circuit diagram of the sixth embodiment;
FIG.16 is a cross sectional view generally showing a seventh embodiment of the semiconductor device according to the present invention;
FIG.17 is a cross sectional view generally showing an example of a structure formed by using the semiconductor device according to the present invention; and
FIG.18 is a cross sectional view generally showing another example of a structure formed by using the semiconductor device according to the present invention.

### DESCRIPTION OF THE PREFERRED EMBODIMENTS

The present inventors have found from experiments that when a plurality of semiconductor light receiving elements are formed in a semiconductor device to make a dual balanced optical receiver, it is not only necessary to minimize the difference in the characteristics of the semiconductor light receiving elements but also prevent the balance and characteristics of the semiconductor light receiving elements from deteriorating due to the effects of wire bonding and the like.

In order to eliminate the undesirable effects of the wire bonding and the like, the present inventors have also found from experiments that it is effective to take the following measures. First, the semiconductor device is formed using the flip-chip bonding and the optical signal is input from a bottom surface of the chip. Second, the semiconductor light receiving elements and the related pads are arranged with a symmetrical layout on approximately the same plane.

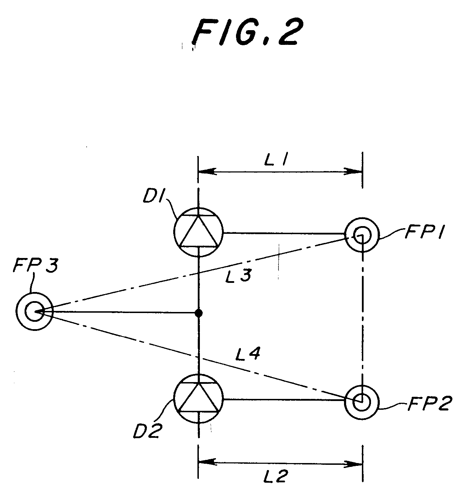

A description will now be given of the operating principle of the semiconductor device according to the present invention, by referring to FIG.2. In FIG.2, those parts which are essentially the same as those corresponding parts in FIG.1 are designated by the same reference numerals.

The semiconductor device shown in FIG.2 comprises flip-chip bonding pads FP1 and FP2, an electrical signal output pad FP3 employing the flip-chip bonding method, and the pin photodiodes D1 and D2. L1 denotes a distance between the pin photodiode D1 and the pad FP1, L2 denotes a distance between the pin photodiode D2 and the pad FP2, L3 denotes a distance between the pads FP3 and FP1, and L4 denotes a distance between the pads FP3 and FP2. Of course, the pads FP1 and FP2 can be used as the positive and negative power source pads.

In this semiconductor device, the layout is such that L1 = L2 and L3 = L4 and an imaginary line which connects the pads FP1, FP2 and FP3 has the shape of an isosceles triangle.

By making a symmetrical layout of the pin photodiodes D1 and D2 and the pads FP1 though FP3, it is possible to eliminate the deterioration of the balance and characteristics of the semiconductor device.

The symmetrical layout is not limited to that shown in FIG.2 and various other symmetrical layouts exist.

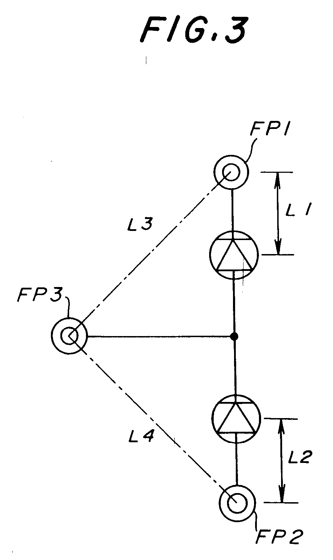

FIG.3 shows a semiconductor device in which the pin photodiodes D1 and D2 and the pads FP1 and FP2 are arranged on a single straight line. In FIG.3, those parts which are essentially the same as those corresponding parts in FIG.2 are designated by the same reference numerals.

In this semiconductor device, the layout is such that an imaginary line which connects the pads FP1, FP2 and FP3 also has the shape of an isosceles triangle and L3 = L4.

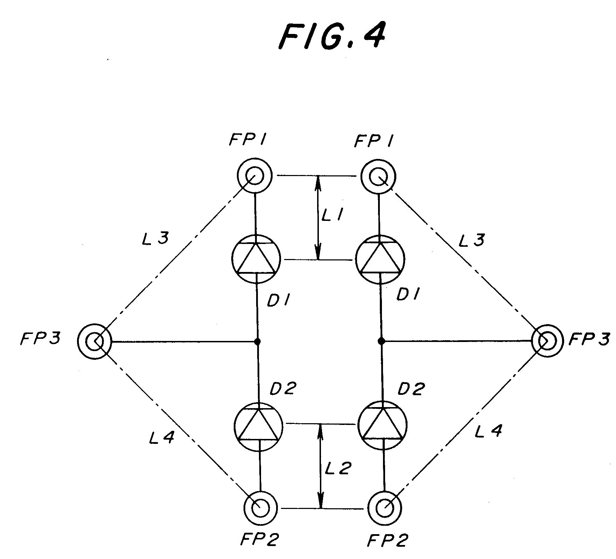

FIG.4 shows a semiconductor device in which a pair of dual balanced optical receivers coexist. In FIG.4, those parts which are essentially the same as those corresponding parts in FIGS.2 and 3 are designated by the same reference numerals.

In this semiconductor device, the symmetrical layout must be maintained between the two dual balanced optical receivers.

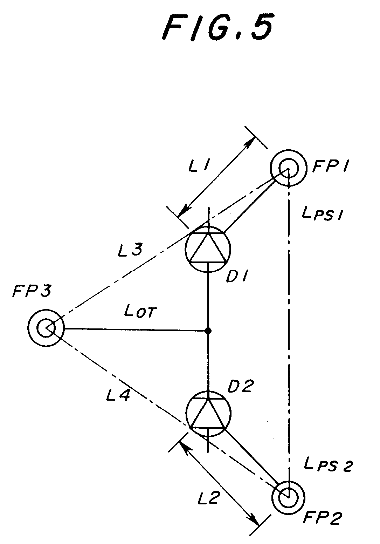

FIG.5 shows a semiconductor device in which the arrangement of the pads FP1 and FP2 is different from those shown in FIGS.2 and 3. In other words, the pads FP1 and FP2 are located obliquely to the respective pin photodiodes D1 and D2. In FIG.5, those parts which are essentially the same as those corresponding parts in FIGS.2 through 4 are designated by the same reference numerals.

In the semiconductor device shown in FIG.5, power source voltage supply lines L_{PS1} and L_{PS2} and an electrical signal output line L_{OT} are made of a metal. The layout is such that L1 = L2 and L3 = L4 and an imaginary line which connects the pads FP1, FP2 and FP3 has the shape of an isosceles triangle. When the pads FP1 and FP2 respectively are positive and negative power source pads and the lines L_{PS1}, L_{PS2} and L_{OT} are made of a metal, it is desirable that the lines L_{PS1}, L_{PS2} and L_{OT} are not provided in parallel to each other.

Therefore, in the semiconductor device according to the present invention, two semiconductor light receiving elements which are connected in series are formed on a single substrate in the form of a monolithic integrated circuit. For example, the substrate is a semiinsulating InP substrate, and the semiconductor light receiving elements are the pin photodiodes D1 and D2. A first flip-chip bonding pad for outputting the electrical signal from a node which connects the two semiconductor light receiving elements and second and third flip-chip bonding pads for supplying positive and negative power source voltages to respective ends of the series connected semiconductor light receiving elements are also provided on the substrate. For example, the first flip-chip bonding pad is the pad FP3, and the second and third flip-chip bonding pads respectively are the pads FP1 and FP2. For example, an imaginary line connecting the first through third flip-chip bonding pads has the shape of an isosceles triangle, where the first through third flip-chip bonding pads are located at vertexes of the isosceles triangle. The distance between the first and second flip-chip bonding pads is set the same as the distance between the first and third flip-chip bonding pads.

According to the semiconductor device of the present invention, the optical and electrical balance and characteristics of the plurality of semiconductor light receiving elements and the related pads are satisfactory, and the semiconductor device is suited for application to the dual balanced optical receiver.

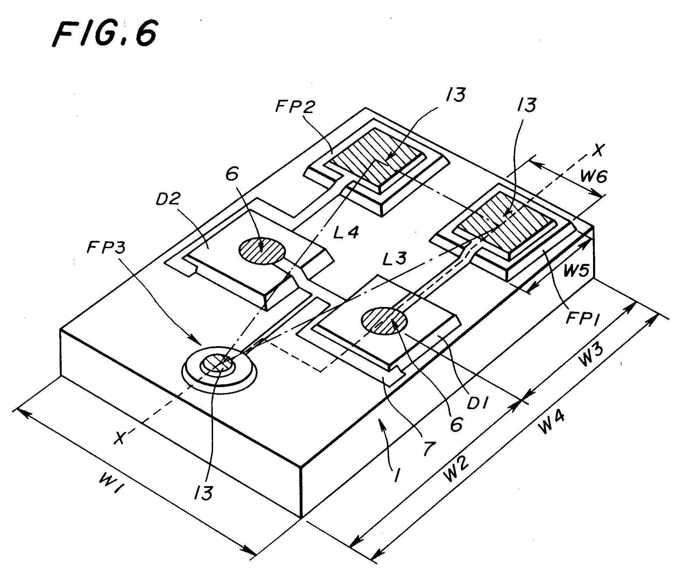

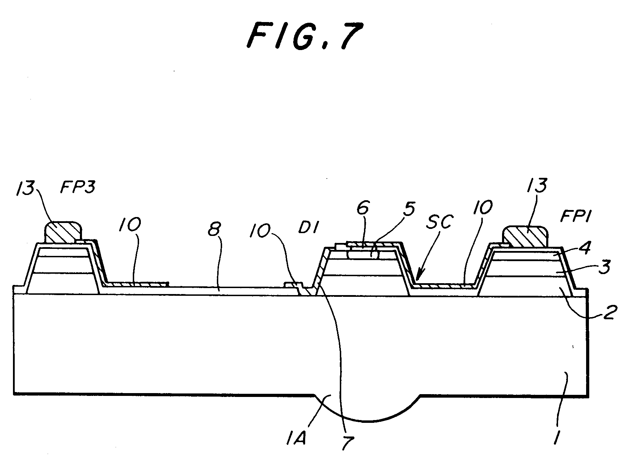

Next, a description will be given of a first embodiment of the semiconductor device according to the present invention, by referring to FIGS.6 and 7. FIG.6 is a perspective view showing an essential part of the first embodiment, and FIG.7 is a cross sectional view of the first embodiment along a line X-X in FIG.6. In FIGS.6 and 7, those parts which are essentially the same as those corresponding parts in FIGS.2 through 5 are designated by the same reference numerals.

In FIGS.6 and 7, the semiconductor device comprises a semiinsulating InP substrate 1, a lens 1A which is provided on a bottom surface of the substrate 1, an n⁺-type InP buffer layer 2, an undoped InGaAs active layer 3, an n⁻-type InP cap layer 4, a p-type region 5 which is formed by diffusing Zn, a p side electrode 6 which is made up of a AuZn/Au stacked structure, an n side electrode 7 which is made up of a AuGe/Au stacked structure, a SiN layer 8, an interconnection 10 which is made up of a Ti/Au stacked structure, and a bump 13 which includes AuSn as the main component.

In this embodiment, the pads FP1, FP2 and FP3 are located at the vertexes of an isosceles triangle which is formed by an imaginary line connecting the pads FP1, FP2 and FP3. In addition, L3 = L4.

For example, the dimension of the parts of this embodiment are as follows. The distances W1 through W6 are selected such that W1 = 250 µm, W2 = W3 = 150 µm, W4 = W2+W3 = 300 µm, and W5 = W6 = 40 µm.
In addition, the diameter of the light absorbing part at the p side electrode 6 is 20 µm, and the diameter of the bump 13 is 15 µm.

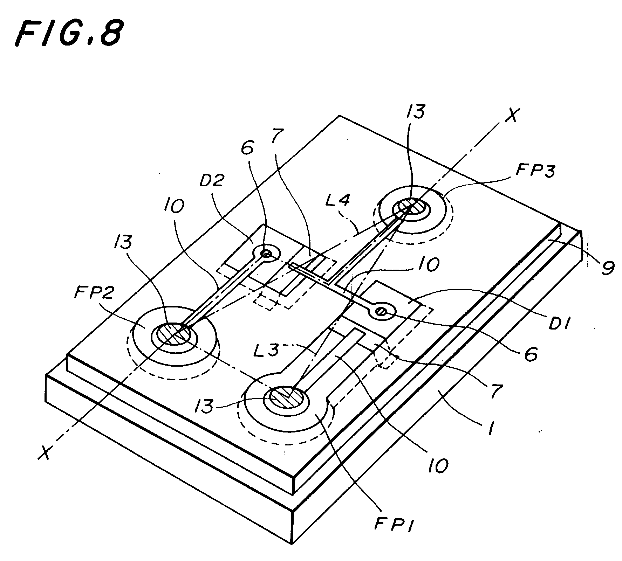

Next, a description will be given of a second embodiment of the semiconductor device according to the present invention, by referring to FIG.8. In FIG.8, those parts which are essentially the same as those corresponding parts in FIGS.2 through 7 are designated by the same reference numerals.

In FIG.8, the semiconductor device comprises a photosensitive polyimide resin layer 9. The resin layer 9 fills depressions at the top surface of the semiconductor device. For this reason, the top surface of the semiconductor is flat even though the mesa structure of the pin photodiodes D1 and D2 and the bumps of the flip-chip bonding pads FP1 and FP2 exist. Moreover, it is possible to considerably reduce the stray electrostatic capacitance.

In the embodiment shown in FIG.7, for example, the side surface of the n⁺-type InP buffer layer 2 is always exposed because the pin photodiodes D1 and D2 have the mesa structure. The interconnection 10 is formed on the exposed side surface of the n⁺-type InP buffer layer 2 via the SiN layer 8. Thus, it is inevitable that the stray electrostatic capacitance is generated at a portion SC indicated by an arrow in FIG.7. But according to this embodiment, the interconnection. 10 passes above the resin layer 9 and the stray capacitance is reduced.

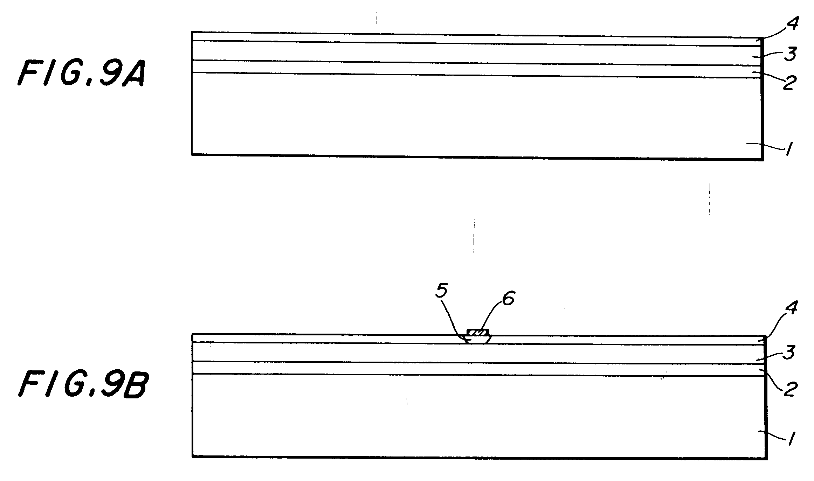

Next, a description will be given of a method of producing the embodiment shown in FIG.8, by referring to FIGS.9A through 9D. FIGS.9A through 9D respectively show the cross section of the semiconductor device along a line X-X in FIG.8 at various stages of the production process. In FIGS.9A through 9D, those parts which are essentially the same as those corresponding parts in FIGS.2 through 8 are designated by the same reference numerals.

Note that 1Å = 0.1 nm and that 1 Torr = 133.3 Pa.

In FIG.9A, a metal organic vapor phase epitaxial (MOVPE) is used to successively form on the semiinsulating InP substrate 1 the n⁺-type InP buffer layer 2, the undoped InGaAs active layer 3 and the n⁻-type InP cap layer 4. For example, the data on the layers 2 through 4 are as follows.
Buffer layer 2:
Thickness: 1.5 µm
Impurity density: 1 x 10¹⁸ cm⁻³
Active layer 3:
Composition: In_{0.47}Ga_{0.53}As
Thickness: 2.8 µm
Cap layer 4:
Thickness: 1.0 µm
Impurity density: 1 x 10¹⁶ cm⁻³

In FIG.9B, a plasma chemical vapor deposition (CVD) is used to form a SiN layer on the cap layer 4. For example, this SiN layer has a thickness in the order of 1000 Å (0.1 µm). Then, a wet etching using a buffer fluorine as the etchant is used to selectively etch the SiN layer so as to form an opening which corresponds to a portion where the p-type impurity region of the pin photodiode is to be formed. Next, a closed-tube type vapor phase diffusion technique is used to form the p-type region 5 by using the SiN layer as a mask, introducing Zn to the cap layer 4 and carrying out a thermal process at 500°C for 30 minutes. Thereafter, the SiN layer which is used as the mask when forming the p-type region 5 is removed.

A resist process of a normal photolithography technique is used to form a photoresist layer which has an opening at a portion where the p side electrode 6 is to be formed. By using a vacuum evaporation, an electrode layer is formed on the entire top surface of the semiconductor device. For example, the electrode layer is made up of a Au/Zn/Au stacked structure, where the thicknesses of the layers making up the Au/Zn/Au stacked structure are 100 Å/60 Å/340 Å. Then, the semiconductor device is submerged in acetone to remove the photoresist layer. The p side electrode 6 is formed by making a patterning by the lift-off of the electrode layer. Next, an alloying thermal process is carried out at 430°C for 5 minutes.

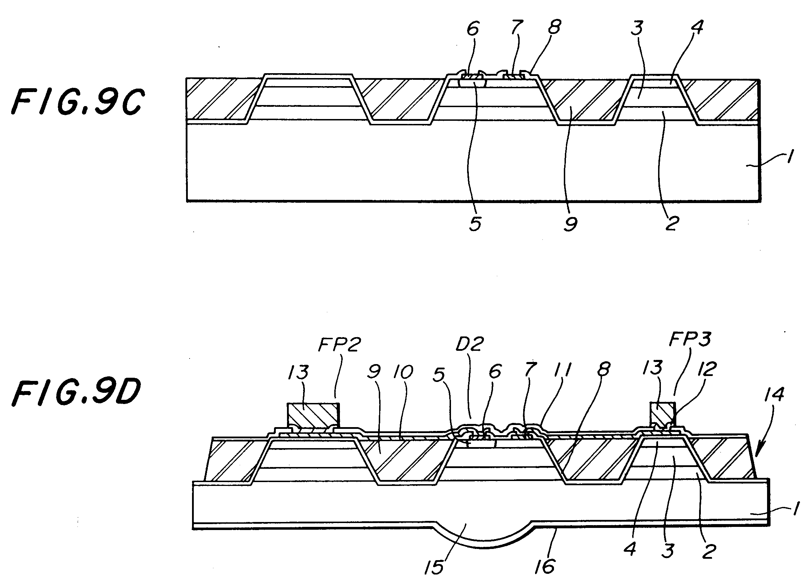

In FIG.9C, a resist process of the normal photolithography technique is used to form a photoresist layer which covers the pin photodiode portion and the pad portion. For example, a photoresist AZ manufactured by Hoechst of West Germany may be used for forming the photoresist layer. An ion beam etching using Ar ions is used to carry out a mesa etching which is made from the surface of the semiconductor device to the semiinsulating InP substrate 1. This ion beam etching is carried out under the following conditions.
Ar gas pressure: 2 x 10⁻⁴ Torr
Ion beam incident angle: 75°
Ion current: 200 mA
Acceleration voltage: 500 V

The n side electrode 7 is formed by using a resist process of the normal photolithography technique, a vacuum evaporation and a lift-off technique. For example, the n side electrode 7 is made up of a AuGe/Au stacked structure, where the thicknesses of the layers making up the AuGe/Au stacked structure are 500 Å/1000 Å. An alloying thermal process is carried out at 380°C for 1 minute. The SiN layer 8 is then formed to a thickness in the order of 2000 Å, for example, by using the plasma CVD. The resin layer 9 is formed on the entire top surface of the semiconductor device by using a spin-coat technique.

Then, the resin layer 9 is patterned by use of a resist process of the normal photolithography technique, and a curing is carried out thereafter at 200°C, 300°C and 400°C respectively for 30 minutes. The SiN layer 8 is selectively etched by use of a wet etching using a buffer fluorine as the etchant, and contact holes are respectively formed above the p and n side electrodes 6 and 7.

In FIG.9D, the interconnection 10 is formed by using a resist process of the normal photolithography technique, a vacuum evaporation and a lift-off technique. For example, the interconnection 10 is made up of a Ti/Au stacked structure, where the thicknesses of the layers making up the Ti/Au stacked structure are 1000 Å/2000 Å. The SiN layer 11 is formed to a thickness in the order of 2000 Å, for example, by using the plasma CVD. The SiN layer 11 is selectively etched by use of the wet etching using a buffer fluorine as the etchant, and contact holes are formed in bump regions of the flip-chip bonding pads.

A Ti/Pt layer 12 which functions as a barrier metal is formed on the entire top surface of the semiconductor device by using an electron beam vapor deposition. For example, the thicknesses of the layers making up the Ti/Pt layer 12 are 1000 Å/2000 Å. Then, a photoresist layer having openings at portions where the bumps are to be formed is formed by a resist process of the normal photolithography technique.

A bump 13 is formed by carrying out a Sn plating with a thickness of 5 µm, for example, using a selective plating technique. A protection layer made up of a photoresist is formed on the surface of the bump 13 by using a resist process of the normal photolithography technique. Then, the protection layer on the pump 13 is used as a mask to selectively remove the Ti/Pt layer 12 by using an ion beam etching technique. A groove which corresponds to a scribe line is formed by selectively etching the SiN layer 11 by use of a wet etching using a buffer fluorine as the etchant.

Next, the SiN layer 11 is used as a mask to selectively remove the resin layer 19 and a groove 14 is formed to facilitate the cleaving process which is carried out at a later stage by use of a reactive ion etching (RIE) using oxygen as the reactive gas. For example, 150 µm of the bottom surface portion of the substrate 1 is polished by a mechanical polishing process. Then, the substrate 1 is selectively etched to form a lens 15 which has a center thickness in the order of 9 µm by use of a resist process of the normal photolithography technique and an ion beam etching using Ar ions. A reflection preventing layer 16 which is made of SiN and has a thickness in the order of 2000 Å, for example, is formed on the bottom surface of the substrate 1 including the lens 15 by using a plasma CVD. Finally, a cleaving process is carried out.

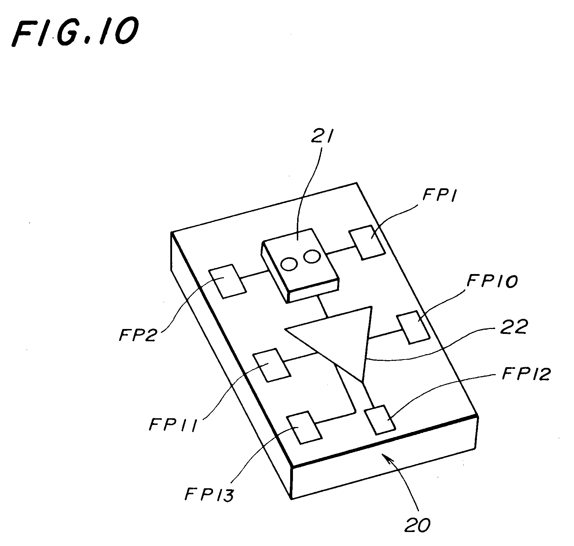

Next, a description will be given of a third embodiment of the semiconductor device according to the present invention, by referring to FIG.10. The semiconductor device shown in FIG.10 comprises a semiinsulating substrate 20, a twin pin photodiode 21 which is made up of a pair of pin photodiodes similar to the pin photodiodes D1 and D2 of the first and second embodiments, an amplifier 22, and pads FP1, FP2 and FP10 through FP13. Outputs of the twin pin photodiode 21 are amplified by the amplifier 22, and this semiconductor device functions as a dual balanced optical receiver.

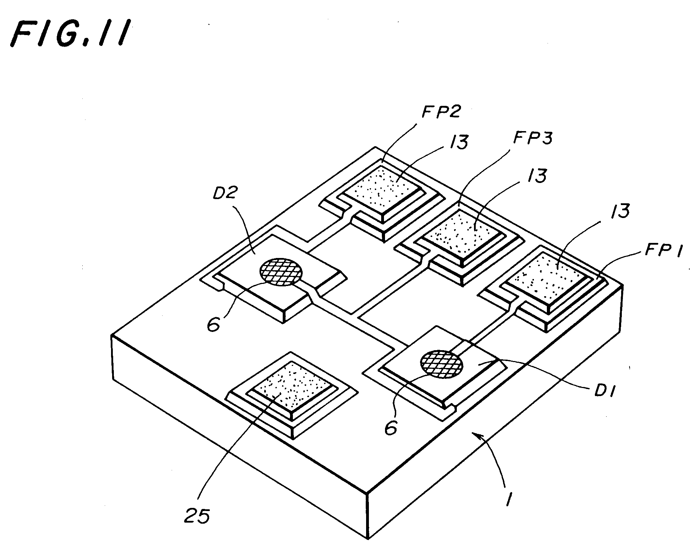

FIG.11 generally shows a fourth embodiment of the semiconductor device according to the present invention. In FIG.11, those parts which are essentially the same as those corresponding parts in FIG.6 are designated by the same reference numerals, and a description thereof will be omitted. In this embodiment, the pads FP1, FP2 and FP3 are aligned no a straight line, and a dummy pad 25 is located on one side of the pin photodiodes D1 and D2 opposite to the side on which the the pads FP1 through FP3 are provided.

In each of the embodiments described above, the pin photodiodes may have various structures in the monolithic integrated circuit. A description will hereunder be made of embodiments of the structure of the pin photodiodes.

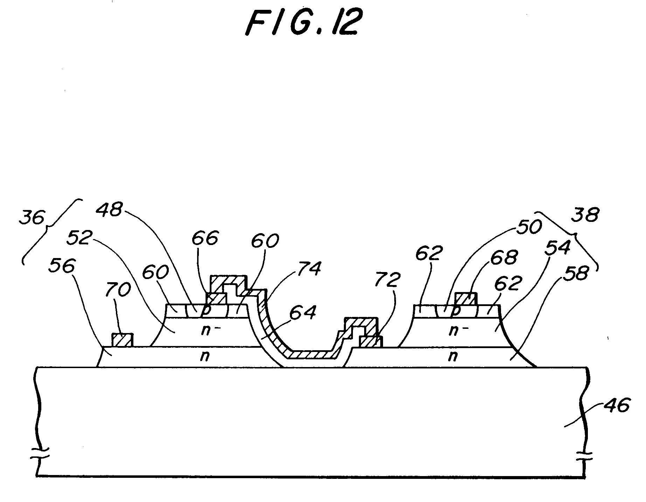

FIG.12 generally shows a fifth embodiment of the semiconductor device according to the present invention. Two pin photodiodes 36 and 38 are formed adjacent to each other with a mesa structure on a semiinsulating substrate 46. The pin photodiode 36 comprises a p-type layer 48, an intrinsic layer 52, and an n-type layer 56. The pin photodiode 48 comprises a p-type layer 50, an intrinsic layer 54, and an n-type layer 58. The side surfaces of the p-type layers 48 and 50 are respectively surrounded by n-type layers 60 and 62. The n-type layers 56 and 58 respectively connect to the substrate 46.

The mesa surfaces of the p-type layers 48 and 50, the intrinsic layers 52 and 54 and the n-type layers 56 and 58 and the surface of the substrate 76 between the pin photodiodes 36 and 38 are covered by a passivation layer 64. In addition, p side contact electrodes 66 and 68 are respectively formed on the p-type layers 48 and 50, and n side contact electrodes 70 and 72 are respectively formed on the n-type layers 56 and 58. The p side contact electrode 36 of the pin photodiode 36 and the n side contact electrode 72 of the pin photodiode 38 are connected by a metal interconnection layer 74 which is formed on the passivation layer 64.

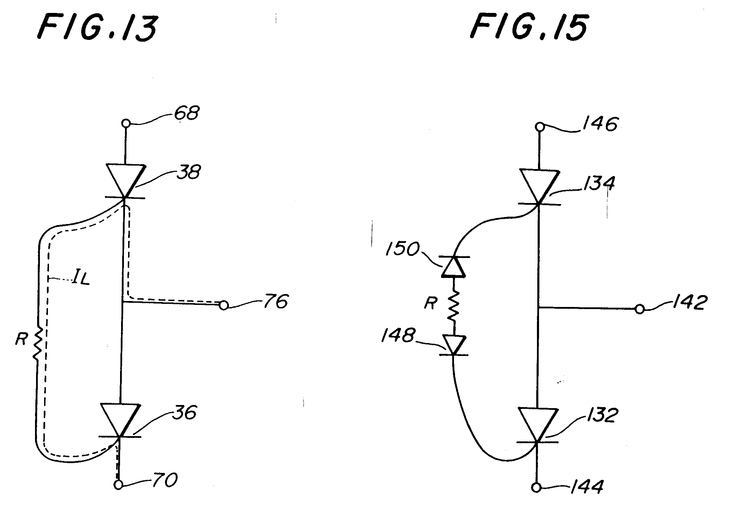

But according to this structure, there is a leakage path due to defects within the substrate 46. In addition, there is a leakage path at the surface of the substrate 46 due to the interface state and a generation of the surface inversion layer at the interface between the substrate 46 and the passivation layer 64. For this reason, when a reverse bias is applied across the n side contact electrode 70 of the pin photodiode 36 and the p side contact electrode 68 of the pin photodiode 38, an equivalent circuit of the twin pin photodiode which is made up of the pin photodiodes 36 and 38 becomes as shown in FIG.13. As may be seen from FIG.13, a leak current I_{L} indicated by a phantom line flows from the n side contact electrode 70 of the pin photodiode 36 to the n side contact electrode 72 (that is, an output terminal 76) of the pin photodiode 38 via a leakage path within the substrate 46 or at the surface of the substrate 46. A resistor R corresponds to the resistances of the leakage path within the substrate 46 and the leakage path at the surface of the substrate 46.

The leak current I_{L} may become several tens of µA or greater. As a result, the leak current I_{L} deteriorates the characteristic and reliability of the pin photodiodes 36 and 38, and the performance of the dual balanced optical receiver becomes poor.

Accordingly, a description will be given of embodiments in which the generation of the leak current is positively prevented to improve the performance of the dual balanced optical receiver.

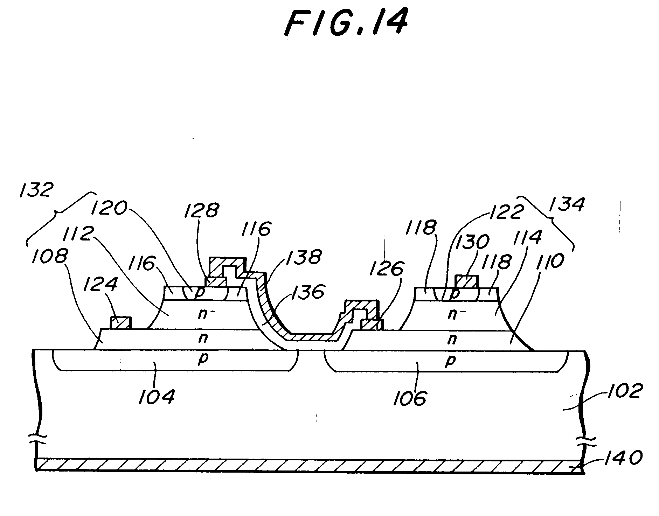

A sixth embodiment of the semiconductor device according to the present invention will now be described with reference to FIG.14. In FIG.14, p-type InP regions 104 and 106 having an impurity density of 10¹⁵ to 10¹⁶ cm⁻³ are formed at adjacent to each other at the surface portion of a semiinsulating InP substrate 102. An n-type InP layer 108 having a thickness of 2 µm and an impurity density of 10¹⁸ cm⁻³, an n⁻-type InGaAs layer 112 having a thickness of 2.5 µm and an impurity density of 10¹⁵ cm⁻³ and an n-type InP layer 116 having a thickness of 1 µm and an impurity density of 10¹⁶ cm⁻³ are lattice matched and successively formed on the p-type InP layer 104. Similarly, an n-type InP layer 110 having a thickness of 2 µm and an impurity density of 10¹⁸ cm⁻³, an n⁻-type InGaAs layer 114 having a thickness of 2.5 µm and an impurity density of 10¹⁵ cm⁻³ and an n-type InP layer 118 having a thickness of 1 µm and an impurity density of 10¹⁶ cm⁻³ are lattice matched and successively formed on the p-type InP layer 106.

P-type InP regions 120 and 122 of high impurity densities are respectively formed at predetermined locations of the n-type InP layers 116 and 118. The p-type InP regions 120 and 122 respectively make contact with the n⁻-type InGaAs layers 112 and 114. N side contact electrodes 124 and 126 are respectively formed on the n-type InP layers 108 and 110. P side contact electrodes 128 and 130 are respectively formed on the p-type InP regions 120 and 122. In order to reduce the photodiode capacitance, a light receiving diameter of light receiving parts excluding parts from the surface of the p-type InP regions 120 and 122 to the p side contact electrodes 128 and 130 is suppressed to 20 µm.

Accordingly, a pin photodiode 132 which is made up of the p-type InP region 120, the n⁻-type InGaAs layer 112 and the n-type InP layer 108 is formed adjacent to a pin photodiode 134 which is made up of the p-type InP region 122, the n⁻-type InGaAs layer 114 and the n-type InP layer 110.

The mesa surfaces of the n-type InP layers 108 and 110, the n⁻-type InGaAs layers 112 and 114, the n-type InP layers 116 and 118 and the p-type InP regions 120 and 122 and the surface of the substrate 102 between the two pin photodiodes 132 and 134 are covered by an SiN passivation layer 136. In addition, the p side contact electrode 128 of the pin photodiode 132 and the n side contact electrode 126 of the pin photodiode 134 are connected by a metal interconnection layer 138 which is formed on the SiN passivation layer 136. A metallized surface 140 made of Au or the like is formed on the bottom surface of the substrate 102 for chip-bonding the semiconductor device on a ceramic substrate, for example.

The impurity density of the p-type InP regions 104 and 106 is desirably in the range of approximately 10¹⁵ to 10¹⁶ cm⁻³. If the impurity density is too low, an effective pn junction cannot be formed between the n-type InP layers 108 and 110. On the other hand, if the impurity density is too high, a breakdown may occur between the p-type InP regions 104 and 106 and the n-type InP layers 108 and 110. Accordingly, the upper limit of the impurity density of the p-type InP regions 104 and 106 is set to a value such that it is possible to obtain a breakdown withstand voltage which is approximately the same or greater than the voltage applied to the pin photodiodes 132 and 134.

It is not essential to provide both the p-type InP regions 104 and 106 for the respective pin photodiodes 132 and 134. For example, it is possible to provide only the p-type InP region 104 between the n-type InP layer 108 and the substrate 102 for the pin photodiode 132.

Next, a description will be given of a method of producing the semiconductor device shown in FIG.14. The p-type InP regions 104 and 106 are selectively formed at two adjacent locations of the surface portion of the InP substrate 102 by diffusing Zn or by ion implantation of Cd, Zn or Be ions and the like. A metal organic chemical vapor deposition (MOCVD) is used to successively form an n-type InP layer, an n⁻-type InGaAs layer and an n-type InP layer with lattice matching on the p-type InP regions 104 and 106 and the InP substrate 102. Zn is diffused into the n-type InP layer to form p-type InP regions 120 and 122 of high impurity density, so that the p-type InP regions 120 and 122 make contact with the n⁻-type InGaAs layer.

Next, a mesa etching is carried out with respect to the n-type InP layer, the n⁻-type InGaAs layer and the n-type InP layer to isolate these layers into two pin structures. One pin structure comprises the n-type InP layer 108, the n⁻-type InGaAs layer 112, the n-type InP layer 116 and the p-type InP region 120. Another pin structure comprises the n-type InP layer 110, the n⁻-type InGaAs layer 114, the n-type InP layer 118 and the p-type InP region 122.

Then, a mesa etching is carried out with respect to the n⁻-type InGaAs layers 112 and 114 and the n-type InP layers 116 and 118 so as to expose portions of the n-type InP layers 108 and 110. The exposed portions of the n-type InP layers 108 and 110 are used for forming a contact electrode thereon.

Thereafter, the SiN passivation layer 136 is formed on the entire top surface of the semiconductor device. That is, the mesa surfaces of the n-type InP layers 108 and 110, the n⁻-type InGaAs layers 112 and 114, the n-type InP layers 116 and 118 and the p-type Inp regions 120 and 122 and the surface of the InP substrate 102 between the two pin structures are covered by the SiN passivation layer 136. Contact holes are formed at predetermined positions using a lithography technique, and the n side contact electrodes 124 and 126 made of AuGe are respectively formed on the n-type InP layers 108 and 110 and the p side contact electrodes 128 and 130 are respectively formed on the p-type InP regions 120 and 122.

The metal interconnection layer 138 which connects the p side contact electrode 128 of the pin photodiode 132 and the n side contact electrode 126 of the pin photodiode 134 is formed on the SiN passivation layer 136.

In addition, a metallized surface 140 which is made of Au or the like is formed on the bottom surface of the InP substrate 102. For example, the metallized surface 140 is used for chip-bonding the semiconductor device on a ceramic substrate, for example.

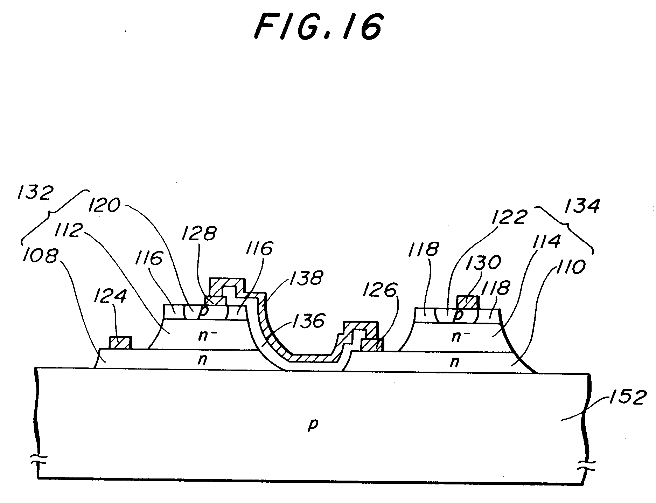

Next, a description will be given of the operation of the sixth embodiment, by referring to FIG.15 which shows an equivalent circuit of this embodiment. In FIG.15, the two pin photodiodes 132 and 134 are connected in series, and an output terminal 142 is connected to a node which connects the two pin photodiodes 132 and 134. In addition, the n side contact electrode 124 of the pin photodiode 132 and the p side contact electrode 130 of the pin photodiode 134 are respectively connected to terminals 142 and 144.

As in the case of the conventional semiconductor device, it is possible to consider leakage paths in the pin photodiodes 132 and 134, that is, a leakage path due to defects within the substrate 102 and a leakage path at the interface between the substrate 102 and the SiN passivation layer 136. However, in this embodiment, the p-type InP region 104 is provided between the n-type InP layer 108 of the pin photodiode 132 and the substrate 102 and the p-type InP region 106 is provided between the n-type InP layer 110 of the pin photodiode 134 and the substrate 102. For this reason, diodes 148 and 150 are formed as shown in FIG.15. The diode 148 has a pn junction Which is made by the p-type InP region 104 and the n-type InP layer 108, and the diode 150 has a pn junction which is made by the p-type InP region 106 and the n-type InP layer 110. A resistor R between the diodes 148 and 150 corresponds to a resistances of a leakage path within the substrate 102 and a leakage path at the surface of the substrate 102.

Accordingly, even when a predetermined voltage is applied across the terminals 142 and 144 so that the pin photodiodes 132 and 134 are reverse biased, a leak current I_{L} which flows from the n side contact electrode 124 of the pin photodiode 132 to the n side contact electrode 126 of the pin photodiode 134 via the the leakage path within the substrate 102 or at the surface of the substrate 102 is blocked by the diode 148 which is connected in a reverse direction to the current flow. In other words, the diode 148 prevents the leak current I_{L} from flowing to the output terminal 140.

According to this sixth embodiment, the diode 148 which is connected in the reverse direction to the flow of the leak current I_{L} is formed by the provision of the p-type InP region 104 between the n-type InP layer 108 of the pin photodiode 132 and the substrate 102 and the p-type InP region 106 between the n-type InP layer 110 of the pin photodiode 134 and the substrate 102. As a result, the leak current I_{L} is reduced to a value which is at least 1/100 the value of the leak current in the fifth embodiment.

Next, a description will be given of a seventh embodiment of the semiconductor device according to the present invention, by referring to FIG.16. In FIG.16, those parts which are essentially the same as those corresponding parts in FIG.14 are designated by the same reference numerals, and a description thereof will be omitted. In this embodiment, a p-type InP substrate 152 which has an impurity density of approximately 10¹⁵ to 10¹⁶ cm⁻³ is used in place of the InP substrate 102 of the sixth embodiment. In addition, the p-type InP regions 104 and 106 and the metallized surface 140 of the sixth embodiment are omitted. Hence, the n-type InP layers 108 and 110 and the SiN passivation layer 136 are formed directly on the p-type InP substrate 152.

In this embodiment, diodes are formed to block the leak current I_{L} similarly to the sixth embodiment. One diode has a pn junction which is made by the p-type InP substrate 152 and the n-type InP layer 108 of the pin photodiode 132, and another diode has a pn junction which is made by the p-type InP substrate 152 and the n-type InP layer 110 of the pin photodiode 134. The effects of this embodiment are basically the same as those obtainable in the sixth embodiment.

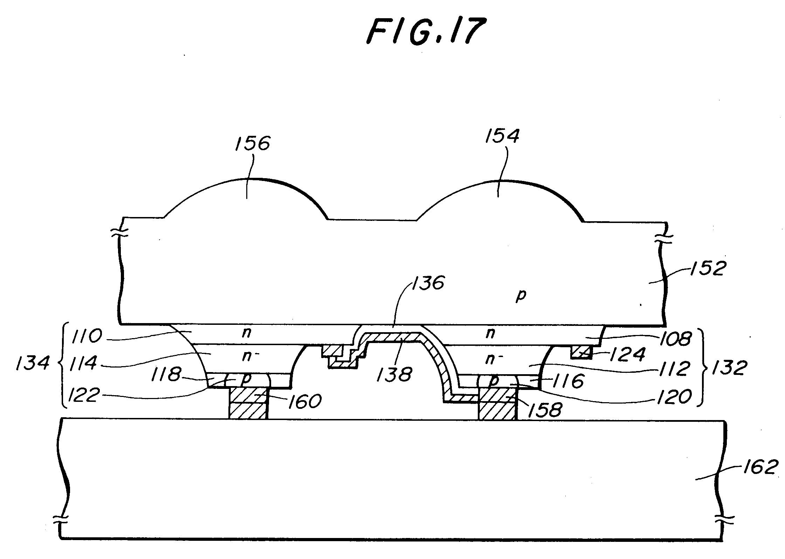

Next, a description will be given as an example and not forming part of the present invention of a structure which can be used with the semiconductor device according to the present invention, by referring to FIG.17. In FIG.17, those parts which are essentially the same as those corresponding parts in FIG.16 are designated by the same reference numerals, and a description thereof will be omitted. In this embodiment, converging lenses 154 and 156 are formed on the back surface of the p-type InP substrate 152 at positions corresponding to the two pin photodiodes 132 and 134. There is no need to provide light receiving parts at the surfaces of the p-type InP regions 120 and 122, and only p side contact electrodes 158 and 160 are formed. The p side contact electrodes 158 and 160 are used for flip-chip bonding the semiconductor device onto a ceramic substrate 162.

In this example, it is possible to obtain effects which are basically the same as those obtainable in the seventh embodiment. In addition, it is possible to reduce the size of the pin photodiodes 132 and 134 and accordingly reduce the stray capacitance because the converging lenses 154 and 156 ensure appropriate light reception at the pin photodiodes 132 and 134. Moreover, although the stray capacitance increases when the p-type InP substrate 152 of the seventh embodiment is bonded directly on the ceramic substrate, this example eliminates the deficiency of the seventh embodiment by flip-chip bonding the semiconductor device onto the ceramic substrate 162 by way of the p side contact electrodes 158 and 160.

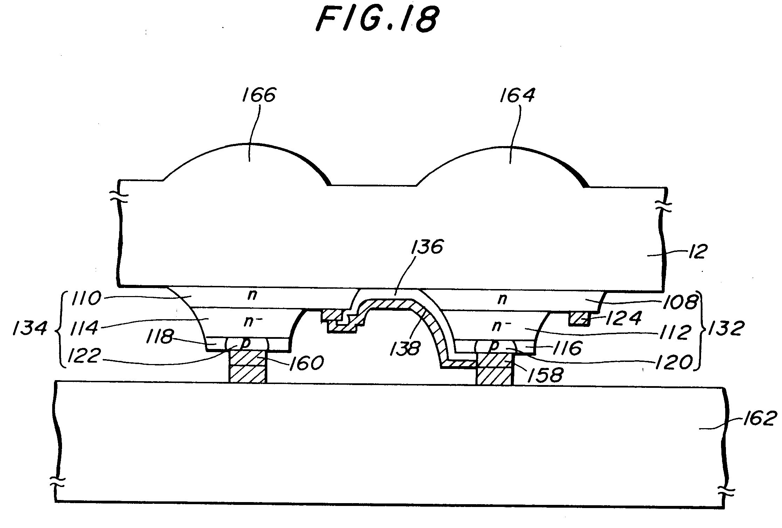

Next, a description will be given as another example and not forming part of the present invention of a structure which can be used with the semiconductor device according to the present invention, by referring to FIG.18. In FIG.18, those parts which are essentially the same as those corresponding parts in FIGS.14 and 17 are designated by the same reference numerals, and a description thereof will be omitted. In this example, no metallized surface 140 is used. Converging lenses 164 and 166 are formed on the back surface of the InP substrate 102. P side contact electrodes 168 and 170 are used for flip-chip bonding the semiconductor device onto the ceramic substrate 162.

According to this example, it is possible to obtain effects which are basically the same as those obtainable in the eighth embodiment.

In the described embodiments, the photodiodes are described as being pin photodiodes. However, the present invention is of course applicable to photodiodes of other types such as lateral pin photodiodes, avalanche photodiodes, and metal semiconductor metal (MSM) photodiodes.

In addition, the substrate material is not limited to InP and other materials such as GaAs and AlGaAs may be used. For example, InGaAs, GaAs or the like may be used for the light absorbing layer in the case of a Si substrate. InGaAs or the like may be used for the light absorbing layer in the case of a InP substrate. GaAs or the like may be used for the light absorbing layer in the case of an AlGaAs substrate.

## Claims

1. A semiconductor device comprising a substrate (1, 46, 102, 152); and first and second semiconductor light-receiving elements (D1, D2; 36, 38; 132, 134) monolithically integrated on the substrate and being connected in series via a node, the light-receiving elements each having a first terminal and a second, opposite, terminal, the second terminal of the first semiconductor light-receiving element and the first terminal of the second semiconductor light-receiving element being connected to this node,
characterized in that there are further provided on the surface of the semiconductor device: a first flip-chip bonding pad (FP3) electrically coupled to the node; and second and third flip-chip bonding pads (FP1, FP2) electrically coupled to said first terminal of the first semiconductor light-receiving element and to said second terminal of the second semiconductor light-receiving element, respectively, the bonding pads being spaced apart from the light-receiving elements and the layout of the light-receiving elements (D₁, D₂) and second and third pads (FP1, FP2) being substantially symmetrical about a line passing through the first pad (FP3), so that the distance (L3) between the centers of the first and second flip-chip bonding pads (FP3, FP1) is approximately the same as the distance (L4) between the centers of the first and third flip-chip bonding pads (FP3, FP2).

2. A semiconductor device as claimed in claim 1, in which the distance (L1) between the centers of the second flip-chip bonding pad (FP1) and of the first semiconductor light-receiving element (D1, 36) is approximately the same as the distance (L2) between the centers of the third flip-chip bonding pad (FP2) and of the second semiconductor light-receiving element (D2, 38).

3. A semiconductor device as claimed in claim 1 or 2, in which an imaginary line connecting the centers of the first, second and third flip-chip bonding pads (FP3, FP1, FP2) forms an isosceles triangle, the centers of the bonding pads corresponding to the vertices of the isosceles triangle.

4. A semiconductor device as claimed in any preceding claim, in which there is further provided at least one dummy pad (25) which is formed on the surface of the semiconductor device, the distance between the centers of the dummy pad and of the second flip-chip bonding pad (FP1) being approximately the same as the distance between the centers of the dummy pad and of the third flip-chip bonding pad (FP2).

5. A semiconductor device as claimed in claim 4, in which an imaginary line connecting the centers of the dummy pad (25) and the second and third flip-chip bonding pads (FP1, FP2) forms an isosceles triangle, the centers of the pads corresponding to the vertices of the isosceles triangle.

6. A semiconductor device as claimed in any of claims 1 to 3, in which the first and second semiconductor light-receiving elements (D1, D2, 36, 38, 132, 134) are *pin* photodiodes.

7. A semiconductor device as claimed in claim 6, in which the first and second photodiodes respectively have a first n-type layer (2; 56, 58; 108, 110) formed on the substrate, a second n-type layer (3; 52, 54; 112, 114) formed on the first n-type layer, a third n-type layer (4; 60, 62; 116, 118) formed on the second n-type layer, a p-type region (5; 48, 50; 120, 122) formed in the third n-type layer, a first electrode (70, 72; 124, 126) formed on the first n-type layer, and a second electrode (66, 68; 128, 130) formed on the p-type region; and further comprising an interconnection layer (10, 74, 138) which corresponds to the node and connects the second electrode of the first diode to the first electrode of the second diode, the first electrode of the first diode corresponding to the said first terminal and the second electrode of the second diode corresponding to the said second terminal.

8. A semiconductor device as claimed in claim 7, further including a passivation layer (8, 64,136) which covers exposed surfaces of the first to third n-type layers of the first and second diodes (D1, D2; 36, 38; 132, 134) between the second electrode of the first diode and the first electrode of the second diode, and an exposed surface of the substrate between the first and second diodes, the interconnection layer (10, 74, 138) being formed on the passivation layer.

9. A semiconductor device as claimed in claim 7 or 8, in which the substrate (102) is made of a semi-insulating material and the semiconductor device further comprises a second p-type region (104, 106) which is formed at a surface portion of the substrate underneath the first n-type layer (108, 110).

10. A semiconductor device as claimed in claim 9, further including a metallization (140) on the surface of the substrate (102) opposite to the said exposed surface.

11. A semiconductor device as claimed in claim 7 or 8, in which the substrate is made of a p-type material.

12. A semiconductor device as claimed in claim 9 or 11, further including a lens portion (15), formed on the surface of the substrate (1, 102) opposite to the said exposed surface at a position corresponding to the position of the first p-type region (5) in order to converge light on this p-type region.

13. A semiconductor device as claimed in any of claims 9 to 12, in which the first n-type layer (2; 56, 58; 108, 110) is made of n-type InP, the second n-type layer (3; 52, 54; 112, 114) is made of n-type InGaAs, the third n-type layer (4; 60, 62; 116, 118) is made of n-type InP, and the first p-type region (5; 48, 50; 120, 122) is made of p-type InP.

14. A semiconductor device as claimed in any preceding claim and further including a second substrate to which the said flip-chip bonding pads (FP3, FP1, FP2) are bonded.

## Patentansprüche

1. Eine Halbleiteranordnung mit einem Substrat (1, 46, 102, 152); und ersten und zweiten Halbleiterlichtempfangselementen (D1, D2; 36, 38; 132, 134), die auf dem Substrat monolithisch integriert sind und über einen Knoten seriell verbunden sind, welche Lichtempfangselemente jeweils erste Anschlüsse haben, die zweiten Anschlüssen gegenüberliegen, wobei der zweite Anschluß des ersten Halbleiterlichtempfangselementes und der erste Anschluß des zweiten Halbleiterlichtempfangselementes mit diesem Knoten verbunden sind,
dadurch gekennzeichnet, daß auf der Oberfläche der Halbleiteranordnung ferner vorgesehen sind: eine erste Flip-Chip-Bondinsel (FP3), die mit dem Knoten elektrisch gekoppelt ist; und zweite und dritte Flip-Chip-Bondinseln (FP1, FP2), die mit dem genannten ersten Anschluß des ersten Halbleiterlichtempfangselementes bzw. dem genannten zweiten Anschluß des zweiten Halbleiterlichtempfangselementes elektrisch gekoppelt sind, wobei die Bondinseln von den Lichtempfangselementen räumlich getrennt angeordnet sind und das Layout der Lichtempfangselemente (D1, D2) und der zweiten und dritten Anschlußinseln (FP1, FP2) um eine Linie herum, die durch die genannte erste Anschlußinsel (FP3) verläuft, im wesentlichen symmetrisch ist, so daß der Abstand (L3) zwischen den Mitten der ersten und zweiten Flip-Chip-Bondinseln (FP3, FP1) etwa derselbe wie der Abstand (L4) zwischen den Mitten der ersten und dritten Flip-Chip-Bondinseln (FP3, FP2) ist.

2. Eine Halbleiteranordnung nach Anspruch 1, bei der der Abstand (L1) zwischen den Mitten der zweiten Flip-Chip-Bondinsel (FP1) und des ersten Halbleiterlichtempfangselementes (D1, 36) etwa derselbe wie der Abstand (L2) zwischen den Mitten der dritten Flip-Chip-Bondinsel (FP2) und des zweiten Halbleiterlichtempfangselementes (D2, 38) ist.

3. Eine Halbleiteranordnung nach Anspruch 1 oder 2, bei der eine imaginäre Linie, die die Mitten der ersten, zweiten und dritten Flip-Chip-Bondinseln (FP3, FP1, FP2) verbindet, ein gleichschenkliges Dreieck bildet, wobei die Mitten der Bondinseln den Ecken des gleichschenkligen Dreiecks entsprechen.

4. Eine Halbleiteranordnung nach irgendeinem vorhergehenden Anspruch, bei der ferner wenigstens eine Blindanschlußinsel (25) vorgesehen ist, die auf der Oberfläche der Halbleiteranordnung gebildet ist, wobei der Abstand zwischen den Mitten der Blindanschlußinsel und der zweiten Flip-Chip-Bondinsel (FP1) etwa derselbe wie der Abstand zwischen den Mitten der Blindanschlußinsel und der dritten Flip-Chip-Bondinsel (FP2) ist.

5. Eine Halbleiteranordnung nach Anspruch 4, bei der eine imaginäre Linie, die die Mitten der Blindanschlußinsel (25) und der zweiten und dritten Flip-Chip-Bondinseln (FP1, FP2) verbindet, ein gleichschenkliges Dreieck bildet, wobei die Mitten der Anschlußinseln den Ecken des gleichschenkligen Dreiecks entsprechen.

6. Eine Halbleiteranordnung nach irgendeinem der Ansprüche 1 bis 3, bei der die ersten und zweiten Halbleiterlichtempfangselemente (D1, D2, 36, 38, 132, 134) *pin*-Fotodioden sind.

7. Eine Halbleiteranordnung nach Anspruch 6, bei der die ersten und zweiten Fotodioden jeweils eine erste n-Typ-Schicht (2; 56, 58; 108, 110) haben, die auf dem Substrat gebildet ist, eine zweite n-Typ-Schicht (3; 52, 54; 112, 114), die auf der ersten n-Typ-Schicht gebildet ist, eine dritte n-Typ-Schicht (4; 60, 62; 116, 118), die auf der zweiten n-Typ-Schicht gebildet ist, eine p-Typ-Zone (5; 48, 50; 120, 122), die in der dritten n-Typ-Schicht gebildet ist, eine erste Elektrode (70, 72; 124, 126), die auf der ersten n-Typ-Schicht gebildet ist, und eine zweite Elektrode (66, 68; 128, 130), die auf der p-Typ-Zone gebildet ist; und die ferner eine Zwischenverbindungsschicht (10, 74, 138) umfaßt, die dem Knoten entspricht und die zweite Elektrode der ersten Diode mit der ersten Elektrode der zweiten Diode verbindet, wobei die erste Elektrode der ersten Diode dem genannten ersten Anschluß entspricht und die zweite Elektrode der zweiten Diode dem genannten zweiten Anschluß entspricht.

8. Eine Halbleiteranordnung nach Anspruch 7, die ferner eine Passivierungsschicht (8, 64, 136) enthält, die exponierte Oberflächen der ersten bis dritten n-Typ-Schichten der ersten und zweiten Dioden (D1, D2; 36, 38; 132, 134) zwischen der zweiten Elektrode der ersten Diode und der ersten Elektrode der zweiten Diode und eine exponierte Oberfläche des Substrats zwischen den ersten und zweiten Dioden bedeckt, wobei die Zwischenverbindungsschicht (10, 74, 138) auf der Passivierungsschicht gebildet ist.

9. Eine Halbleiteranordnung nach Anspruch 7 oder 8, bei der das Substrat (102) aus einem halbisolierenden Material hergestellt ist und die Halbleiteranordnung ferner eine zweite p-Typ-Zone (104, 106) umfaßt, die an einem Oberflächenabschnitt des Substrats unter der ersten n-Typ-Schicht (108, 110) gebildet ist.

10. Eine Halbleiteranordnung nach Anspruch 9, die ferner eine Metallisierung (140) auf der Oberfläche des Substrats (102) enthält, die der genannten exponierten Oberfläche gegenüberliegt.

11. Eine Halbleiteranordnung nach Anspruch 7 oder 8, bei der das Substrat aus einem p-Typ-Material hergestellt ist.

12. Eine Halbleiteranordnung nach Anspruch 9 oder 11, die ferner einen Linsenabschnitt (15) enthält, der auf der Oberfläche des Substrats (1, 102), die der genannten exponierten Oberfläche gegenüberliegt, an einer Position gebildet ist, die der Position der ersten p-Typ-Zone (5) entspricht, um Licht auf diese p-Typ-Zone konvergieren zu lassen.

13. Eine Halbleiteranordnung nach irgendeinem der Ansprüche 9 bis 12, bei der die erste n-Typ-Schicht (2; 56, 58; 108, 110) aus n-Typ-InP hergestellt ist, die zweite n-Typ-Schicht (3; 52, 54; 112, 114) aus n-Typ-InGaAs hergestellt ist, die dritte n-Typ-Schicht (4; 60, 62; 116, 118) aus n-Typ-InP hergestellt ist und die erste p-Typ-Zone (5; 48, 50; 120, 122) aus p-Typ-InP hergestellt ist.

14. Eine Halbleiteranordnung nach irgendeinem vorhergehenden Anspruch, die ferner ein zweites Substrat enthält, mit dem die genannten Flip-Chip-Bondinseln (FP3, FP1, FP2) gebondet sind.

## Revendications

1. Dispositif à semiconducteur comprenant un substrat (1, 46, 102, 152) ; et des premier et second éléments de réception de lumière à semiconducteur (D1, D2 ; 36, 38 ; 132, 134) intégrés monolithiquement sur le substrat et connectés en série via un noeud, les éléments de réception de lumière comportant chacun des première et seconde bornes opposées, la seconde borne du premier élément de réception de lumière à semiconducteur et la première borne du second élément de réception de lumière à semiconducteur étant connectées à ce noeud,
caractérisé en ce que sont en outre prévus sur la surface du dispositif à semiconducteur : un premier plot de liaison de puce à protubérances (FP3) couplé électriquement au noeud ; et des second et troisième plots de liaison de puce à protubérances (FP1, FP2) couplés électriquement respectivement à ladite première borne du premier élément de réception de lumière à semiconducteur et à ladite seconde borne du second élément de réception de lumière à semiconducteur, les plots de liaison étant espacés des éléments de réception de lumière et l'implantation des éléments de réception de lumière (D₁, D₂) et des second et troisième plots (FP1, FP2) étant sensiblement symétrique par rapport à une ligne traversant le premier plot (FP3) de telle sorte que la distance (L3) séparant les centres des premier et second plots de liaison de puce à protubérances (FP3, FP1) soit approximativement la même que la distance (L4) séparant les centres des premier et troisième plots de liaison de puce à protubérances (FP3, FP2).

2. Dispositif à semiconducteur selon la revendication 1, dans lequel la distance (L1) séparant les centres du second plot de liaison de puce à protubérances (FP1) et du premier élément de réception de lumière à semiconducteur (D1, 36) est approximativement la même que la distance (L2) séparant les centres du troisième plot de liaison de puce à protubérances (FP2) et du second élément de réception de lumière à semiconducteur (D2, 38).

3. Dispositif à semiconducteur selon la revendication 1 ou 2, dans lequel une ligne imaginaire reliant les centres des premier, second et troisième plots de liaison de puce à protubérances (FP3, FP1, FP2) forme un triangle isocèle, les centres des plots de liaison correspondant aux sommets du triangle isocèle.

4. Dispositif à semiconducteur selon l'une quelconque des revendications précédentes, dans lequel est en outre prévu au moins un plot fictif (25) qui est formé sur la surface du dispositif à semiconducteur, la distance séparant les centres du plot fictif et du second plot de liaison de puce à protubérances (FP1) étant approximativement la même que la distance séparant les centres du plot fictif et du troisième plot de liaison de puce à protubérances (FP2).

5. Dispositif à semiconducteur selon la revendication 4, dans lequel une ligne imaginaire reliant les centres du plot fictif (25) et des second et troisième plots de liaison de puce à protubérances (FP1, FP2) forme un triangle isocèle, les centres des plots correspondant aux sommets du triangle isocèle.

6. Dispositif à semiconducteur selon l'une quelconque des revendications 1 à 3, dans lequel les premier et second éléments de réception de lumière à semiconducteur (D1, D2, 36, 38, 132, 134) sont des photodiodes PIN.

7. Dispositif à semiconducteur selon la revendication 6, dans lequel les première et seconde photodiodes comportent respectivement une première couche de type N (2 ; 56, 58 ; 108, 110) formée sur le substrat, une seconde couche de type N (3 ; 52, 54 ; 112, 114) formée sur la première couche de type N, une troisième couche de type N (4 ; 60, 62 ; 116, 118) formée sur la seconde couche de type N, une région de type P (5 ; 48, 50 ; 120, 122) formée dans la troisième couche de type N, une première électrode (70, 72 ; 124, 126) formée sur la première couche de type N et une seconde électrode (66, 68 ; 128, 130) formée sur la région de type P ; et comprenant en outre une couche d'interconnexion (10, 74, 138) qui correspond au noeud et qui connecte la seconde électrode de la première diode à la première électrode de la seconde diode, la première électrode de la première diode correspondant à ladite première borne et la seconde électrode de la seconde diode correspondant à ladite seconde borne.

8. Dispositif à semiconducteur selon la revendication 7, incluant en outre une couche de passivation (8, 64, 136) qui recouvre des surfaces mises à nu des première à troisième couches de type N des première et seconde diodes (D1, D2 ; 36, 38 ; 132, 134) entre la seconde électrode de la première diode et la première électrode de la seconde diode, et une surface mise à nu du substrat entre les première et seconde diodes, la couche d'interconnexion (10, 74, 138) étant formée sur la couche de passivation.

9. Dispositif à semiconducteur selon la revendication 7 ou 8, dans lequel le substrat (102) est réalisé en un matériau semi-isolant et le dispositif à semiconducteur comprend en outre une seconde région de type P (104, 106) qui est formée au niveau d'une partie de surface du substrat au-dessous de la première couche de type N (108, 110).

10. Dispositif à semiconducteur selon la revendication 9, incluant en outre une métallisation (140) sur la surface du substrat (102) opposée à ladite seconde surface mise à nu.

11. Dispositif à semiconducteur selon la revendication 7 ou 8, dans lequel le substrat est constitué par un matériau de type P.

12. Dispositif à semiconducteur selon la revendication 9 ou 11, incluant en outre une partie de lentille (15) formée sur la surface du substrat (1, 102) opposée à ladite surface mise à nu en une position correspondant à la position de la première région de type P (5) afin de faire converger la lumière sur cette région de type P.

13. Dispositif à semiconducteur selon l'une quelconque des revendications 9 à 12, dans lequel la première couche de type N (2 ; 56, 58 ; 108, 110) est constituée par de l'InP de type N, la seconde couche de type N (3 ; 52, 54 ; 112, 114) est constituée par de l'InGaAs de type N, la troisième couche de type N (4 ; 60, 62 ; 116, 118) est constituée par de l'InP de type N et la première région de type P (5 ; 48, 50 ; 120, 122) est constituée par de l'InP de type P.

14. Dispositif à semiconducteur selon l'une quelconque des revendications précédentes, incluant en outre un second substrat sur lequel lesdits plots de liaison de puce à protubérances (FP3, FP1, FP2) sont liés.
